# EUROPÄISCHE PATENTSCHRIFT

(11) **EP 0 518 086 B1**
(45) Veröffentlichungstag und Bekanntmachung des Hinweises auf die Patenterteilung: **14.08.1996**
(21) Anmeldenummer: 92108480.2
(22) Anmeldetag: 20.05.1992
(51) Int. Cl.: G04G 7/02, H03J 7/06

(54) **Empfängeranordnung**
Radio receiver
Dispositif de réception d'ondes radio

(30) Priorität: 06.08.1991 DE 4125995; 08.06.1991 DE 4118995
(43) Veröffentlichungstag der Anmeldung: 16.12.1992
(73) Patentinhaber: TEMIC TELEFUNKEN microelectronic GmbH, 74072 Heilbronn (DE)
(72) Erfinder: Burkhart, Johann, W-7914 Pfaffenhofen (DE); Traub, Johann, W-8882 Lauingen (DE); Böhme, Rolf, Dr.-Ing., W-7107 Bad Friedrichshall (DE)
(74) Vertreter: Weber, Gerhard, Dipl.-Phys.

(56) Entgegenhaltungen:
- EP-A- 0 305 200
- EP-A- 0 352 853
- DE-A- 2 014 233
- FR-A- 2 444 369
- US-A- 4 241 450
- PATENT ABSTRACTS OF JAPAN, vol. 9, no. 131 (E-1854) 6. Juni 1985 & JP-A-60 016 718
- Herter,Röcker,Lörcher: Nachrichtentechnik, Übertragung, Vermittlung und Verarbeitung, Hanser-Verlag, München, Wien (1981), S. 200-207

## Beschreibung

Die Erfindung betrifft eine Empfängeranordnung zum Empfang und zur Demodulation eines Nutzsignals mit vorgegebener Trägerfrequenz, insbesondere des Funksignals eines Zeitzeichensenders.

Aus der DE 37 33 967 A1 ist eine Anordnung zum Empfang des Funksignals eines Zeitzeichensenders bekannt, bei welcher ein Quadraturdemodulator eingesetzt ist.

Eine weitere Anordnung zum Empfang des Funksignals eines Zeitzeichensenders ist aus der EP 0 305 200 A2 bekannt. Bei dieser Anordnung wird das Funksignal zunächst mittels eines ersten Mischers frequenzumgesetzt und anschließend mittels eines Vollwellengleichrichters durch Hüllkurvengleichrichtung demoduliert.

Demodulationsverfahren für Nutzsignale mit vorgegebener Trägerfrequenz sind aus "Herter, Röcker, Lörcher: Nachrichtentechnik - Übertragung, Vermittlung, Verarbeitung; Hanser-Verlag, München, Wien, 1981" bekannt. Auf Seite 200 - 201 und auf Seite 207 wird dort ein als Synchrondemodulation oder kohärente Demodulation bezeichnetes Verfahren beschrieben, bei dem das Nutzsignal mit einem zu seiner Trägerfrequenz phasensynchronisierten, d. h. mit einem der Trägerfrequenz phasenstarr nachgeführten Oszillatorsignal durch Frequenzumsetzung demoduliert wird.

Aufgabe der vorliegenden Erfindung ist es, eine vorteilhafte Empfängeranordnung der einleitend genannten Art anzugeben.

Wesentlich an der Erfindung ist, daß in einer Vorsynchronisationsphase der erste Regelkreis zuverlässig und eindeutig die Frequenz der Oszillatoranordnung auf einen durch die Ausbildung des ersten Regelkreises und eine separate stabile Referenzfrequenz gegebenen Wert einregelt und daß danach dieselbe Oszillatoranordnung durch Umschaltung des Steuersignals auf einen zweiten Regelkreis phasenrichtig an das Empfangs-Nutzsignal angebunden wird. Der zweite Regelkreis braucht nur einen kleinen Fangbereich aufzuweisen, so daß die Rauschbandbreite sehr gering gehalten werden kann.

Die erfindungsgemäße Anordnung ist besonders vorteilhaft für einen Zeitzeichenempfänger mit Quarzuhr, bei welchem der Uhrenquarz als Referenzfrequenzquelle herangezogen wird.

Die Erfindung ist nachfolgend anhand von Ausführungsbeispielen unter Bezugnahme auf die Abbildungen noch eingehend veranschaulicht.

Das von einer Antenne A aufgenommene Funkempfangssignal wird in einem ggf. mehrstufigen Verstärker mit einstellbarem Verstärkungsgrad verstärkt und durch Mischung mit einem phasenrichtigen Überlagerungssignal u1 in einem ersten Mischer M1 synchron demoduliert. Im skizzierten Beispiel erfolgt vor dem ersten Mischer noch eine Frequenzumsetzung des Eingangssignals in eine Zwischenfrequenzlage durch Mischen des Eingangssignals mit einem dritten Überlagerungssignal u3 in einem dritten Mischer M3. Die Überlagerungssignale u1, u3 werden in einer Oszillatoranordnung erzeugt und vorzugsweise aus einem gemeinsamen Oszillatorsignal durch Frequenzteilung abgeleitet. Im skizzierten Beispiel wird als drittes Überlagerungssignal direkt das Ausgangssignal eines Oszillators O mit der Frequenz fo eingesetzt, aus welchem in einem ersten Frequenzteiler TC das erste Uberlagerungssignal ul der Frequenz fl abgeleitet ist. Der Oszillator O ist über ein Steuersignal t, das eine Steuerspannung oder ein Steuerstrom sein kann, in der Frequenz variabel einstellbar. Zur Gewinnung des Steuersignals t sind zwei Regelkreise vorgesehen, die alternativ über eine Umschalteinrichtung U mit dem Steuereingang des Oszillator verbindbar sind. Die Umschalteinrichtung U wird betätigt über eine Auswerteeinheit AE. Zur Einregelung der Oszillatorfrequenz z.B. nach Einschalten der Empfängeranordnung stellt die Auswerteeinrichtung AE die Umschalteinrichtung U für eine Vorsynchronisationsphase in die mit ausgezogener Linie eingezeichnete Stellung, so daß der erste Regelkreis geschlossen ist.

Der erste Regelkreis regelt die Frequenz fo des Oszillators durch Vergleich mit einer stabilen Referenzfrequenz auf einen Sollwert. Hierzu werden in an sich bekannter Weise das Signal der Referenzfrequenzquelle und das Oszillatorausgangssignal in Frequenzteilern Tn bzw. Tm mit unterschiedlichen Teilerfaktoren n bzw. m frequenzverringert und auf zwei Eingänge eines Phasendetektors PD geführt. Der Phasendetektor PD ist vorzugsweise als digitaler flankengesteuerter Phasendetektor ausgeführt. Das Ausgangssignal s1 des Phasendetektors PD wird als erstes Regelsignal s1 über die Umschalteinrichtung U und ggf. ein Schleifenfilter SF als Steuersignal t dem steuerbaren Oszillator O zugeführt. Der erste Regelkreis ist, vor allem hinsichtlich des Phasendetektors PD, so ausgelegt, daß vom ungeregelten Zustand des Oszillators ausgehend ein eindeutiges Ein regeln der Sollfrequenz gewährleistet ist.

Für den Empfang des Funksignals eines Zeitzeichensenders ist die Empfängeranordnung vorteilhafterweise in Verbindung mit einer Quarzuhr betrieben, wobei die Empfängeranordnung ggf. zur Korrektur einer falschen Einstellung der Quarzuhr herangezogen wird und beispielsweise nur in größeren Zeitabständen, nach Ausfall der Spannungsversorgung o. ä. kurzzeitig in Betrieb ist. In einer solchen Betriebsart ist vorzugsweise die Oszillatorfrequenz der Quarzuhr als Referenzquelle für den ersten Regelkreis mitbenutzt.

Nach Einrasten des ersten Regelkreises schwingt der Oszillator annähernd auf der Sollfrequenz und die Frequenz des ersten Überlagerungssignals u1 stimmt weitgehend mit der Trägerfrequenz f1 des Nutzsignals am Eingang des ersten Mischers überein. Die Genauigkeit der Frequenzeinstellung ist von der Quarzreferenz abhängig und zur Synchrondemodulation i. a. nicht ausreichend. Darüber hinaus ist beim Einrasten des ersten Regelkreises die Phasenlage zwischen erstem Überlagerungssignal u1 und der Trägerfrequenz des am ersten Mischer M1 anliegenden Nutzsignals noch zufällig. Zur exakten Phasensynchronisation der beiden Eingangssignale des ersten Mischers führt ein zweiter Regelkreis das erste Überlagerungssignal u1 der Trägerfrequenz des Nutzsignals am Eingang des ersten Mischers phasenstarr nach. Hierfür schaltet die Auswerteeinrichtung AE nach dem Einrasten des ersten Regelkreises die Umschalteinrichtung U in die mit unterbrochener Linie eingezeichnete Schaltstellung und schließt damit den zweiten Regelkreis. Im zweiten Regelkreis ist als wesentliches Element ein zweiter Mischer M2 vorgesehen, dem zum einen das Empfangssignal vom Eingang des ersten Mischers und zum anderen ein zum ersten Überlagerungssignal ul um 90° phasenverschobenes zweites Überlagerungssignal u2 zugeführt sind. Das Ausgangssignal s2 des zweiten Mischers bildet ein zweites Regelsignal, das in der Demodulationsphase über die Umschalteinrichtung U und das Schleifenfilter SF als Steuersignal t am Steuersignaleingang des Oszillators O anliegt. Die zur Erzeugung der Uberlagerungssignale ul und u2 benötigte 2-Phasen-Oszillatoranordnung ist vorzugsweise durch Einsatz eines Frequenzteilers zur Ableitung beider Signale aus einem gemeinsamen höherfrequenten Signal realisiert. Im skizzierten Beispiel ist hierfür der Frequenzteiler TC vorgesehen. Der Teilerfaktor k dieses Frequenzteilers ist vorzugsweise k = 4, da dann an die Ausgangssignale des z.B. aus einer an sich bekannten mehrstufigen Flip-Flop-Anordnung bestehenden Teilers auch bei nicht idealem Tastverhältnis des Teilereinganssignals immer zuverlässig eine gegenseitige 90°-Phasenverschiebung zeigen. In der Frequenz nicht mit dem zweiten Uberlagerungssignal u2 übereinstimmende Signale im Empfangssignal am Eingang des zweiten Mischers führen zu Wechselsignalanteilen im Ausgangssignal des zweiten Mischers, die im Schleifenfilter SF unterdrückt werden, soweit sie außerhalb dessen Durchlaßbandbreite liegen. Die Bandbreite des Schleifenfilters SF wird zur Verringerung der Rauschbandbreite im Oszillatorsignal möglichst gering gewählt, muß aber die beim Einrasten des ersten Regelkreises noch verbleibenden Frequenzabweichungen erfassen. Für die Betätigung der Umschalteinrichtung U durch die Auswerteeinheit AE sind verschiedene Bewertungen als Umschaltkriterien in der Auswerteeinheit denkbar. Für die Umschaltung von der Vorsynchronisationsphase auf die Demodulationsphase sind zum Beispiel einzeln oder in Verbindung miteinander vorteilhaft
a) Vorgabe einer Mindestdauer für die Vorsynchronisation durch ein Zeitglied τ, z.B. ein Monoflop und/oder
b) Überwachung des ersten Regelsignals auf Erreichen eines stabilen Werts.

Für den Fall, daß der Signalempfang durch schlechte Synchronisation unbefriedigend ist, kann auch eine Rückschaltung der Umschalteinrichtung U von der Demodulations-Schaltstellung auf die Vorsynchronisation-Stellung vorgesehen sein, wofür in der Auswerteeinheit vorzugsweise als Umschaltkriterien einzeln oder gemeinsam
c) das zweite Regelsignal s2 und/oder
d) die decodierten Empfangssignale
überwacht werden. Die Modulation des Nutzsignals darf dabei natürlich keinen Umschaltvorgang auslösen. Es kann eine bestimmte Anzahl von Versuchen zur Demodulation vorgegeben sein, nach deren erfolglosem Erreichen der Vorgang abgebrochen wird. Zur Verringerung des Leistungsverbrauchs können in der Demodulationsphase die nur zur Vorsynchronisation benötigten Schaltungsteile wie die Teiler Tm und Tn und der Phasendetektor PD abgeschaltet werden. Die Ausführung der Auswerteeinheit im Detail ist auf vielfältige Weise möglich. Insbesondere kann die Auswerteeinheit aufgeteiltsein in für verschiedene Kriterien getrennte Bewertungsschaltungen und/oder die Auswerteeinheit kann durch eine Verarbeitungsvorschrift in einem auch für andere Aufgaben vorgesehenen Prozessor realisiert sein. Die verschiedenen Bewertungskriterien in der Auswerteeinheit sind in der Skizze durch strichpunktierte Verbindungslinien zu den entsprechenden Signalpunkten repräsentiert. Das Ausgangssignal des ersten Mischers M1 wird durch einen Tiefpaß TP gefiltert, so daß bei korrekter Einstellung des zweiten Regelkreises am Ausgang des Tiefpasses TP eine von dem demodulierten Nutzsignal herrührende Gleichspannung vorliegt. Diese ist für den Fall des Zeitzeichensenders DCF 77 pegelmoduliert durch wiederkehrende kurzzeitige Pegelreduzierung auf 25 % des maximalen Pegels. Diese Pegel sprünge im demodulierten Signal werden in einer Schaltung ST mit Schnitt-Trigger-Verhalten in zweiwertige Datensignale umgeformt und in einem Dekoder Dec dekodiert.

Aus dem demodulierten und tiefpaßgefilterten Empfangssignal wird mittels eines Pegeldetektors und Steuersignalgenerators in einer an sich bekannten Verstärkungsregelschaltung AGC ein Steuersignal g für den steuerbaren Verstärker gewonnen. Der Vollweggleichrichter G ist vorteilhaft für die Verstärkungsregelung in der Vorsynchronisationsphase, in welcher das Ausgangssignal des Tiefpaßfilters TP bei nicht exakter Frequenzübereinstimmung zwischen Nutzsignal und erstem Überlagerungssignal noch niederfrequent varriiert bzw. bei ungünstiger Phasenlage zwischen diesen beiden Signalen verschwinden oder negative Werte annehmen kann, wodurch für den Verstärkungsregelkreis beim Umschalten auf die Demodulationsphase eine Einstellung vorliegen könnte, bei der die einwandfreie Funktion des zweiten Regelkreises nicht gewährleistet wäre. Der Vollweggleichrichter G bewirkt, daß auch in der Vorsynchronisationsphase eine ungefähre Voreinstellung des Verstärkungsregelkreises möglich ist. In der Demodulationsphase, wenn am Ausgang des Tiefpasses TP ohnehin eine positive Gleichspannung vorliegt, hat der Vollweggleichrichter keine Bedeutung.

Durch Einsatz frequenzselektiver Mittel vor dem ersten Mischer kann das Phasenrauschen im ersten Überlagerungssignal und damit auch die Qualität der demodulierten Signale deutlich verbessert werden. Am Ausgang des Verstärkers V liegt ein ggf. durch eine resonante Antennenankopplung vorgefiltertes breitbandiges Signal fe vor. Durch Einsatz eines auf die Trägerfrequenz f1 des am Eingang des ersten Mischers M1, ggf. nach Frequenzumsetzung in eine Zwischenfrequenzlage fz im Mischer M3, anliegenden Nutzsignals abgestimmten Bandfilters BP können störende Frequenzanteile weitgehend beseitigt werden. Besonders vorteilhaft ist der Einsatz eines steuerbaren Bandpaßfilters, dessen Mittenfrequenz über ein Steuersignal t' einstellbar ist. Das steuerbare Bandfilter ist vorzugsweise weitgehend gleich aufgebaut wie der steuerbare Oszillator O. Da die Trägerfrequenz des Nutzsignals am Eingang des Mischers gleich ist der Frequenz des ersten Überlagerungssignals, die über das Steuersignal t eingestellt ist, ist es vorteilhaft, das Steuersignal t' für das steuerbare Bandfilter BP in gleicher Weise aus dem Regelkreis abzuleiten wie das Steuersignal t für den Oszillator oder auch nur ein einheitliches Steuersignal t = t' zu generieren und sowohl dem Oszillator O als auch dem Filter BP zuzuführen.

Bei einer Anordnung wie skizziert mit Frequenzumsetzung des Eingangssignals mit einem dritten Uberlagerungssignal u3 der Frequenz fo in einem dritten Mischer und Ableiten des ersten Uberlagerungssignals u1 aus dem dritten Überlagerungssignal durch Frequenzteilung mit einem Teilerfaktor k = 4 ist für den Empfang des DCF 77 -Zeitzeichensignals auf 77,5 kHz beispielsweise für die Oszillatorfrequenz fo ein Wert von 62 kHz zu wählen, wodurch das Nutzsignal im Zwischenfrequenzbereich bei 15,5 kHz liegt, was genau der Frequenz des aus u3 abgleiteten ersten Uberlagerungssignals u1 entspricht, f1 = fo/4 = 15,5 kHz. Bei einem gebräuchlichen Schwingquarz Q mit einer Schwingfrequenz von 32768 Hz werden die Teilerfaktoren im ersten Regelkreis vorteilhafterweise zu m = 70 und n = 37 oder m = 333 und n = 176 gewählt, um eine Oszillatorfrequenz von ca. 62 kHz einzuregeln. Für den Empfang eines Zeitzeichensenders auf der Frequenz 60 kHz kann die Frequenz des dritten Überlagerungssignals u3 beispielsweise fo = 80 kHz und die des ersten Uberlagerungssignals f1 = 20 kHz oder fo = 48 kHz und f1 = 12 kHz betragen.

Weitere Beispiele und Abwandlungen liegen im Bereich fachmännischen Könnens. Insbesondere kann die Frequenz des dritten Überlagerungsignals von der Oszillatorfrequenz abweichen und aus dieser ebenfalls durch Frequenzteilung hervorgegangen sein. Auf die Zwischenfrequenzumsetzung und damit auf das dritte Überlagerungssignal kann auch ganz verzichtet werden. Weiters kann es vorteilhaft sein, statt des Schleifenfilters SF zwei getrennte Schleifenfilter vorzusehen, um ggf. unterschiedliche Anforderungen an die Regeleigenschaften in der Vorsynchronisationsphase und der Demodulationsphase zu berücksichtigen.

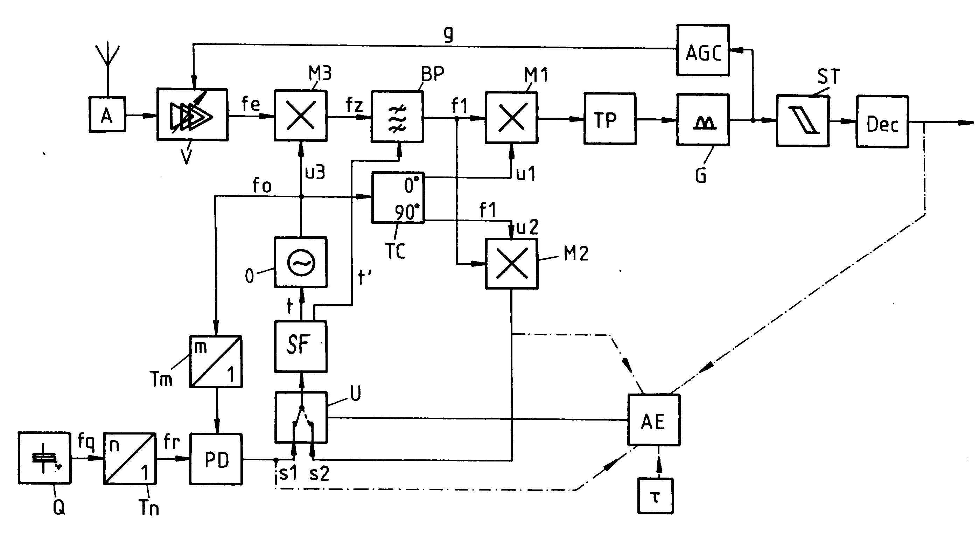

## Patentansprüche

1. Empfängeranordnung zum Empfang und zur Demodulation eines Nutzsignals mit gegebener Trägerfrequenz, insbesondere des Funksignals eines Zeitzeichensenders, die einen im Signalweg der Empfängeranordnung liegenden ersten Mischer (M1), eine steuerbare Oszillatoranordnung und eine stabile Referenzfrequenzquelle (Q) aufweist, dadurch gekennzeichnet, daß
a) der Signalweg in der Empfängeranordnung nach dem Empfangsprinzip der Synchrondemodulation aufgebaut ist,
b) die steuerbare Oszillatoranordnung ein erstes Überlagerungssignal (u1) für die Synchrondemodulation des Nutzsignals im ersten Mischer (M1) erzeugt,
c) ein erster Regelkreis mit der Referenzfrequenzquelle (Q) und mit einem Phasendetektor (PD) großen Fangbereiches zur Regelung der Frequenz des ersten Überlagerungssignals (u1) ein erstes Regelsignal (s1) für die Oszillatoranordnung erzeugt,
d) ein zweiter Regelkreis zur Phasensynchronisation des ersten Überlagerungssignals (u1) mit der Trägerfrequenz des Nutzsignals ein zweites Regelsignal (s2) für die Oszillatoranordnung erzeugt,
e) eine Umschalteinrichtung (U) in einer Vorsynchronisationsphase das erste Regelsignal (s1) und in einer nachfolgenden Demodulationsphase das zweite Regelsignal (s2) an den Steuersignaleingang der Oszillatoranordnung legt.

2. Anordnung nach Anspruch 1, dadurch gekennzeichnet, daß sie in Verbindung mit einer Quarzuhr betrieben ist und die Referenzquelle das Signal des Quarzoszillators der Quarzuhr ist.

3. Anordnung nach Anspruch 1 oder 2, dadurch gekennzeichnet, daß der erste Regelkreis einen digitalen Phasendetektor enthält.

4. Anordnung nach einem der Ansprüche 1 bis 3, dadurch gekennzeichnet, daß die Frequenzen der Referenzquelle und der Oszillatoranordnung verschieden sind und über Frequenzteiler (Tm, Tn) mit unterschiedlichen Teilerfaktoren (m, n) dem Phasendetektor (PD) des ersten Regelkreises zugeführt sind.

5. Anordnung nach einem der Ansprüche 1 bis 4, dadurch gekennzeichnet, daß der zweite Regelkreis einen zweiten Mischer (M2) enthält, dem das Nutzsignal vom Eingang des ersten Mischers (M1) und ein zum ersten Überlagerungssignal (u1) um π/2 phasenverschobenes zweites Überlagerungssignal (u2) der Oszillatoranordnung zugeführt sind.

6. Anordnung nach Anspruch 5, dadurch gekennzeichnet, daß das erste und das zweite Überlagerungssignal (u1, u2) durch Frequenzteilung (TC) aus einem gemeinsamen Oszillatorsignal abgeleitet sind.

7. Anordnung nach einem der Ansprüche 1 bis 6, gekennzeichnet durch frequenzselektive Mittel (BP) im Signalweg vor dem ersten Mischer (M1).

8. Anordnung nach Anspruch 7, dadurch gekennzeichnet, daß die frequenzselektiven Mittel ein steuerbares Filter enthalten, dessen Steuersignal (t') wie das Steuersignal (t) für die Oszillatoranordnung aus den Regelsignalen des ersten und zweiten Regelkreises abgeleitet ist.

9. Anordnung nach Anspruch 7 oder 8, dadurch gekennzeichnet, daß die frequenzselektiven Mittel einen dritten Mischer, der das Nutzsignal mit einem dritten Überlagerungssignal (u3) aus der Oszillatoranordnung in eine Zwischenfrequenzlage (fz) umsetzt, und ein Bandpaßfilter (BP) für die Zwischenfrequenz des Nutzsignals enthält.

10. Anordnung nach Anspruch 9, dadurch gekennzeichnet, daß das erste (u1, u2) und das zweite Überlagerungssignal durch Frequenzteilung 4:1 aus dem dritten Überlagerungssignal (u3) abgeleitet sind.

11. Anordnung nach einem der Ansprüche 1 bis 10, dadurch gekennzeichnet, daß die Dauer der Vorsynchronisationsphase durch ein fest eingestelltes Zeitglied (τ) begrenzt ist.

12. Anordnung nach einem der Ansprüche 1 bis 11, dadurch12. Anordnung nach einem der Ansprüche 1 bis 11, dadurch gekennzeichnet, daß die Umschalteinrichtung (U) von einer Auswerteeinheit (AE) gesteuert ist, welche das erste und/oder das zweite Regelsignal (s1, s2) und/oder das decodierte Nutzsignal überwacht.

13. Anordnung nach Anspruch 12, dadurch gekennzeichnet, daß die Auswerteeinheit (AE) die Umschalteinrichtung (U) von der Schaltstellung der Demodulationsphase auf die Schaltstellung der Vorsynchronisationsphase zurückschaltet, wenn die Bewertung der überwachten Signale ergibt, daß kein ordnungsgemäßer Empfang vorliegt.

14. Anordnung nach einem der Ansprüche 1 bis 13, gekennzeichnet durch einen am Empfängereingang angeordneten Verstärker (V) mit steuerbarem Verstärkungsgrad und einem weiteren Regelkreis zur Steuerung des Verstärkers.

15. Anordnung nach einem der Ansprüche 1 bis 14, dadurch gekennzeichnet, daß der weitere Regelkreis einen Pegeldetektor enthält, dem das Ausgangssignal des ersten Mischers zugeführt ist.

16. Anordnung nach Anspruch 14, dadurch gekennzeichnet, daß vor dem Pegeldetektor ein Vollweggleichrichter (G) angeordnet ist.

17. Anordnung nach einem der vorhergehenden Ansprüche, dadurch gekennzeichnet, daß in der Demodulationsphase die ausschließlich zur Vorsynchronisation benötigten Schaltungsteile abgeschaltet werden.

## Claims

1. Receiver arrangement for receiving and demodulating a wanted signal having a given carrier frequency, in particular the radio signal from a standard time signal transmitter, the arrangement comprising a first mixer (M1) in the signal path of the receiver arrangement, a controllable oscillator arrangement and a stable reference frequency source (Q), characterised in that,
a) the signal path in the receiver arrangement is constructed in accordance with the synchronous demodulation method of reception,
b) the controllable oscillator arrangement produces a first heterodyne signal (u1) for synchronously demodulating the wanted signal in the first mixer (M1),
c) a first control loop including the reference frequency source (Q) and including a phase detector (PD) having a large capture range that produces a first control signal (s1) for the oscillator arrangement for controlling the frequency of the first heterodyne signal (u1),
d) a second control loop producing a second control signal (s2) for the oscillator arrangement for phase synchronising the first heterodyne signal (u1) with the carrier frequency of the wanted signal,
e) a switch-over device (U) which applies the first control signal (s1) to the control signal input of the oscillator arrangement in a pre-synchronising phase and the second control signal (s2) to the control signal input of the oscillator arrangement in a subsequent demodulation phase.

2. Arrangement in accordance with Claim 1, characterised in that, it is driven in conjunction with a quartz clock and the reference source is the signal from the quartz oscillator of the quartz clock.

3. Arrangement in accordance with Claim 1 or 2, characterised in that, the first control loop contains a digital phase detector.

4. Arrangement in accordance with any of the Claims 1 to 3, characterised in that, the frequencies of the reference source and of the oscillator arrangement are different and are supplied via frequency dividers (Tm, Tn) having differing division factors (m, n) to the phase detector (PD) of the first control loop.

5. Arrangement in accordance with any of the Claims 1 to 4, characterised in that, the second control loop contains a second mixer (M2) to which there are supplied the wanted signal from the input of the first mixer (M1) and a second heterodyne signal (u2) of the oscillator arrangement which is displaced in phase by π/2 relative to the first heterodyne signal (u1).

6. Arrangement in accordance with Claim 5, characterised in that, the first and the second heterodyne signal (u1, u2) are derived from a common oscillator signal by frequency division (TC).

7. Arrangement in accordance with any of the Claims 1 to 6, characterised by frequency selective means (BP) in the signal path prior to the first mixer (M1).

8. Arrangement in accordance with Claim 7, characterised in that, the frequency selective means include a controllable filter whose control signal (t') is derived, just as the control signal (t) for the oscillator arrangement, from the control signals from the first and second control loop.

9. Arrangement in accordance with Claim 7 or 8, characterised in that, the frequency selective means includes a third mixer, which transposes the wanted signal into an intermediate frequency range (fz) using a third heterodyne signal (u3) from the oscillator arrangement, and a band pass filter (BP) for the intermediate frequency of the wanted signal.

10. Arrangement in accordance with Claim 9, characterised in that, the first and the second heterodyne signal (u1, u2) are derived from the third heterodyne signal (u3) by a frequency division of 4:1.

11. Arrangement in accordance with any of the Claims 1 to 10, characterised in that, the duration of the pre-synchronising phase is limited by a member (τ) that is set to a fixed delay time.

12. Arrangement in accordance with any of the Claims 1 to 11, characterised in that, the switch-over device (U) is controlled by an evaluating unit (AE) which monitors the first and/or the second control signal (s1, s2) and/or the decoded wanted signal.

13. Arrangement in accordance with Claim 12, characterised in that, the evaluating unit (AE) switches the switch-over device (U) back from the switch position in the demodulation phase into the switch position in the pre-synchronising phase if the assessment of the monitored signals indicates that reception is not being effected properly.

14. Arrangement in accordance with any of the Claims 1 to 13, characterised by an amplifier (V) having a controllable amplification factor arranged at the input of the receiver and a further control loop for controlling the amplifier.

15. Arrangement in accordance with any of the Claims 1 to 14, characterised in that, the further control loop contains a level detector to which the output signal of the first mixer is supplied.

16. Arrangement in accordance with Claim 14, characterised in that, a full wave rectifier (G) is arranged prior to the level detector.

17. Arrangement in accordance with any of the preceding Claims, characterised in that. the circuit components required exclusively for the pre-synchronising process are switched off in the demodulation phase.

## Revendications

1. Récepteur en vue de la réception et de la démodulation d'un signal utile de fréquence porteuse déterminée, en particulier du signal radio d'un émetteur de signaux horaires, qui comporte un premier mélangeur (M1) se trouvant dans le trajet de signal du récepteur, un oscillateur commandé et une source de fréquence de référence stable (Q), caractérisé en ce que
a) le trajet de signal dans le récepteur est réalisé selon le principe de réception de la modulation synchrone,
b) l'oscillateur commandé génère un premier signal de conversion (u1) pour la démodulation synchrone du signal utile dans le premier mélangeur (M1),
c) un premier circuit de réglage équipé de la source de fréquence de référence (Q) et d'un détecteur de phase (PD) de plage de capture large en vue de la régulation de la fréquence du premier signal de conversion (u1) génère un premier signal de réglage (s1) pour l'oscillateur,
d) un deuxième circuit de réglage en vue de la synchronisation de phase du premier signal de conversion (u1) avec la fréquence porteuse du signal utile génère un deuxième signal de réglage (s2) pour l'oscillateur,
e) un dispositif de commutation (U) dans une phase de présynchronisation applique le premier signal de réglage (s1) et au cours d'une phase de démodulation ultérieure, le deuxième signal de réglage (s2) à l'entrée de signal de commande de l'oscillateur.

2. Dispositif selon la revendication 1, caractérisé en ce qu'il est utilisé en liaison avec une horloge à quartz et la source de référence est le signal de l'oscillateur de l'horloge à quartz.

3. Dispositif selon la revendication 1 ou 2, caractérisé en ce que le premier circuit de réglage contient un détecteur de phase numérique.

4. Dispositif selon une des revendications 1 à 3, caractérisé en ce que les fréquences de la source de référence et de l'oscillateur sont différentes et sont appliquées par l'intermédiaire de diviseurs de fréquence (Tm, Tn) de coefficients de division différents (m, n) au détecteur de phase (PD) du premier circuit de réglage.

5. Dispositif selon l'une des revendications 1 à 4, caractérisé en ce que le second circuit de réglage contient un deuxième mélangeur (M2), auquel sont appliqués le signal utile provenant de l'entrée du premier mélangeur (M1) et un deuxième signal de conversion (u2) de l'oscillateur déphasé de π/2 par rapport au premier signal de conversion (u1).

6. Dispositif selon la revendication 5, caractérisé en ce que le premier et le second signal de conversion (u1, u2) sont obtenus par division de fréquence (TC) à partir d'un signal d'oscillateur commun.

7. Dispositif selon l'une des revendications 1 à 6, caractérisé par des moyens sélectifs en fréquence (BP) dans le trajet de signal devant le premier mélangeur (M1).

8. Dispositif selon la revendication 7, caractérisé en ce que les moyens sélectifs en fréquence comportent un filtre réglable, dont le signal de commande (t') ainsi que le signal de commande (t) pour l'oscillateur est prélevé à partir des signaux de réglage du premier et du second circuit de réglage.

9. Dispositif selon la revendication 7 ou 8, caractérisé en ce que les moyens sélectifs en fréquence contiennent un troisième mélangeur, qui convertit le signal utile avec un troisième signal de conversion (u3) provenant de l'oscillateur en une position de fréquence intermédiaire (fz), et contient un filtre passe-bande (BP) pour la fréquence intermédiaire du signal utile.

10. Dispositif selon la revendication 9, caractérisé en ce que le premier et le deuxième signal de conversion (u1, u2) sont obtenus par division de fréquence 4:1 à partir du troisième signal de conversion (u3).

11. Dispositif selon l'une des revendications 1 à 10, caractérisé en ce que la durée de la phase de présynchronisation est limitée par un élément de temporisation fixe (τ).

12. Dispositif selon l'une quelconque des revendications 1 à 11, caractérisé en ce que le dispositif de commutation (U) est commandé par une unité d'évaluation (AE), qui contrôle le premier et/ou le secod signal de réglage (s1, s2) et/ou le signal utile décodé.

13. Dispositif selon la revendication 12, caractérisé en ce que l'unité d'évaluation (AE) ramène le dispositif de commutation (U) de la position de commutation de la phase de démodulation à la position de commutation de la phase de présynchronisation, lorsque l'évaluation des signaux contrôlés indique qu'il n'existe aucune réception normale.

14. Dispositif selon l'une quelconque des revendications 1 à 13, caractérisé par un amplificateur (V) à gain réglable, disposé à l'entrée du récepteur, et un autre circuit de réglage en vue de la commande de l'amplificateur.

15. Dispositif selon l'une quelconque des revendications 1 à 14, caractérisé en ce que l'autre circuit de réglage comprend un détecteur de niveau, auquel est appliqué le signal de sortie du premier mélangeur.

16. Dispositif selon la revendication 14, caractérisé en ce qu'en amont du détecteur de niveau est disposé un redresseur à deux alternances (G).

17. Dispositif selon l'une quelconque des revendications précédentes, caractérisé en ce que durant la phase de démodulation, les éléments de circuit nécessaires exclusivement à la présynchronisation sont coupés.
